# FASCICULE DE BREVET EUROPEEN

(11) **EP 0 549 464 B1**
(45) Date de publication et mention de la délivrance du brevet: **03.03.1999**
(21) Numéro de dépôt: 92403529.8
(22) Date de dépôt: 22.12.1992
(51) Int. Cl.: G01R 31/36

(54) **Procédé de mesure de l'état de charge d'un générateur électro-chimique**
Verfahren zur Messung des Ladezustandes eines elektrochemischen Generators
Method for measuring the state of charge of an electrochemical generator

(30) Priorité: 27.12.1991 FR 9116239
(43) Date de publication de la demande: 30.06.1993
(73) Titulaire: ALCATEL, 75008 Paris (FR)
(72) Inventeur: Andrieu, Xavier, F-91220 Bretigny Sur Orge (FR); Poignant, Philippe, F-91140 Villebon Sur Yvette (FR)
(74) Mandataire: Pothet, Jean Rémy Emile Ludovic

(56) Documents cités:
- GB-A- 1 239 214
- GB-A- 2 046 923
- US-A- 3 676 770
- US-A- 4 333 149
- US-A- 4 644 245
- US-A- 4 719 428

## Description

Le domaine de l'invention est celui des procédés et dispositifs permettant d'indiquer l'état de charge d'un générateur électro-chimique. Ce générateur électro-chimique est par exemple un accumulateur ou constitué d'une batterie d'accumulateurs. On entend par batterie d'accumulateurs un ensemble constitué par une pluralité d'accumulateurs, par exemple connectés en série.

De façon connue, la caractéristique de tension d'un accumulateur en fonction de sa capacité de décharge, par exemple exprimée en Ah, ne présente pas de variation importante pour une grande majorité de caractéristiques de décharge et il n'est donc pas possible de déterminer la charge de cet accumulateur en effectuant une simple mesure de tension à ses bornes. Cette constatation est notamment valable pour les accumulateurs de type nickel-cadmium.

C'est pourquoi les procédés de mesure de l'état de charge d'une batterie font appel soit à des capteurs (capteurs de température de la batterie, de sa pression interne,...), soit à des mesures électriques (mesure de l'impédance interne de la batterie, mesures par coulométrie, mesures impulsionnelles).

Le document US-A-3 676 770 enseigne de provoquer une décharge impulsionnelle d'un générateur électrochimique et de mesurer un courant de décharge dépendant de l'impédance interne du générateur. Comme cette impédance est en relation avec l'état de charge, cette mesure permet, dans certains cas, une connaissance de l'état de charge.

Le document de brevet américain n°4.644.245 de Harry B. BROWN décrit une méthode de mesure de l'état de charge d'une batterie d'accumulateurs nickel-cadmium.

Cette méthode consiste à appliquer, périodiquement et pendant des temps très courts, de l'ordre de 1 ms, une charge résistive de valeur très faible aux bornes de la batterie à tester, de telle sorte qu'un courant important soit débité de cette batterie dans la charge. On obtient ainsi des impulsions de courant de décharge qui font chuter la tension aux bornes de la batterie jusqu'à une valeur de tension qui est mesurée. Cette tension est proportionnelle à l'état de charge de la batterie. Un afficheur permet d'indiquer directement l'état de charge de la batterie, cet état de charge étant proportionnel à la tension délivrée par la batterie lorsque celle-ci débite le courant de décharge. Cette méthode consiste donc à exciter une batterie d'accumulateurs par un courant contrôlé (excitation intensiostatique).

Son principal inconvénient est que l'application d'une contrainte à courant contrôlé suppose que l'on connaisse la capacité de la batterie et la charge résistive appliquée périodiquement aux bornes de la batterie doit donc être adaptée au type d'accumulateur composant cette batterie. En effet, si le courant est débité d'un accumulateur de taille réduite, il se peut que cet accumulateur soit endommagé, si ce courant n'est pas adapté à cet accumulateur. Le dispositif mettant en oeuvre cette méthode de mesure d'état de charge ne peut donc être utilisé pour des générateurs électro-chimiques de types distincts (accumulateurs nickelcadmium, au plomb, nickel-hydrogène, piles,...).

D'autre part, il n'est possible de mesurer l'état de charge de la batterie que lorsque celle-ci n'alimente pas un circuit électrique, c'est à dire hors fonctionnement. En effet, lorsqu'une décharge impulsionnelle est réalisée, la tension fournie par la batterie permettant d'estimer son état de charge peut devenir très faible et même s'annuler si la batterie est proche de son état déchargé. La mesure d'état de charge ne peut donc être effectuée en circuit.

La présente invention a notamment pour objectif de pallier ces inconvénients.

Plus précisément, un des objectifs de l'invention est de fournir un procédé de mesure de l'état de charge d'un générateur électro-chimique qui puisse être utilisé pour des générateurs de type différents, quel que soit leur état de charge originel.

Un autre objectif de l'invention est de fournir un tel procédé de mesure pouvant être mis en oeuvre lorsque ce générateur électro-chimique est en circuit, c'est à dire lorsqu'il alimente un circuit électrique.

Ces objectifs, ainsi que d'autres qui apparaîtront par la suite, sont atteints grâce à un procédé de mesure de l'état de charge d'un générateur électro-chimique selon la presente revendication 1.

Le procédé de l'invention repose donc sur la génération d'une impulsion de tension destinée à provoquer l'apparition d'un courant de décharge du générateur électro!5 chimique dont on veut connaître l'état de charge.

Selon un mode de mise en oeuvre particulier, le générateur électro-chimique est un accumulateur ou une batterie d'accumulateurs.

Avantageusement, la mesure du courant de décharge est effectuée immédiatement avant la fin de cette impulsion de tension.

Préférentiellement, la tension de valeur inférieure à la tension nominale est au moins égale à une tension minimale nécessitée par un circuit électrique dont la source d'alimentation est constituée par le générateur électro-chimique.

Le générateur électro-chimique dont on mesure le courant de décharge peut donc être en circuit, c'est à dire alimenter un montage électrique, et aucune conséquence sur le fonctionnement du montage électrique n'est engendrée par la mesure.

Le procédé de l'invention est avantageusement appliqué à la mesure de l'état de charge d'accumulateurs de type nickel-cadmium.

Un dispositif de mesure de l'état de charge d'un générateur électrochimique comporte :
- une charge permettant de faire débiter sur commande au générateur électrochimique un courant de décharge suffisamment important pour que sa caractéristique d'impédance interne en fonction de son état de charge soit univoque ;
- des moyens de mesure de ce courant de décharge ;
- des moyens pour imposer une tension prédéterminée aux bornes du générateur électrochimique de sorte que la mesure du courant de décharge exprime directement l'état de charge du générateur électrochimique.

Dans un mode de réalisation préférentiel, la charge est constituée par un transistor commandé par les moyens imposant une tension prédéterminée aux bornes du générateur électrochimique.

De préférence, les moyens pour imposer une tension prédéterminée aux bornes du générateur électrochimique sont constitués par un amplificateur opérationnel.

Le générateur électrochimique peut alimenter un circuit électrique dont la tension minimale d'alimentation est inférieure à cette tension prédéterminée imposée aux bornes du générateur électrochimique pendant la mesure de son état de charge.

D'autres caractéristiques et avantages apparaîtront à la lecture de la description suivante d'un mode de mise en oeuvre préférentiel du procédé de l'invention, et des dessins annexés, dans lesquels :
- la figure 1 représente la caractéristique d'impédance d'un accumulateur nickel-cadmium en fonction de son état de charge pour des mesures effectuées sous des contraintes différentes ;
- la figure 2 représente la caractéristique d'admittance de deux accumulateurs nickel-cadmium en fonction de leur état de charge, cette caractéristique étant obtenue par décharge impulsionnelle potentiostatique de durée inférieure à 100 ms ;
- la figure 3 représente un dispositif permettant d'appliquer une impulsion potentiostatique à un accumulateur ;
- la figure 4 est un chronogramme de la tension de commande Ve de la figure 3 et du courant de décharge impulsionnelle traversant la résistance de charge de la figure 3 ;
- la figure 5 représente un autre mode de mise en oeuvre d'un dispositif permettant d'appliquer une impulsion potentiostatique à un accumulateur.

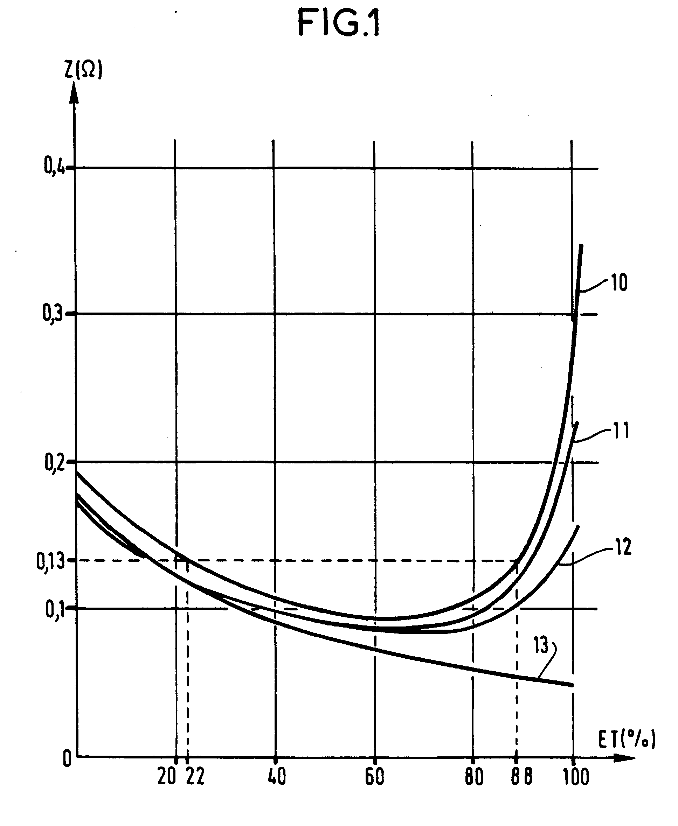

La figure 1 représente la caractéristique d'impédance d'un accumulateur nickel-cadmium en fonction de son état de charge pour des mesures effectuées sous des contraintes différentes.

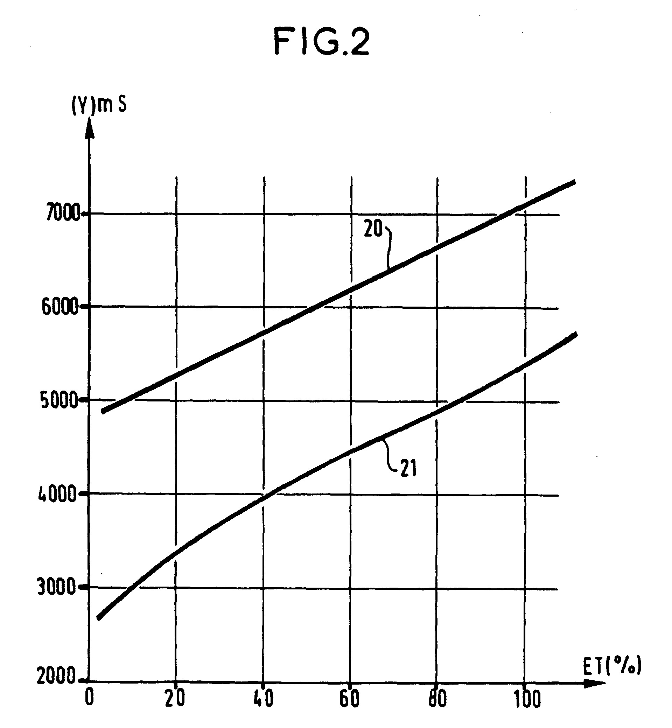

Sur cette figure, ainsi que sur la figure 2, l'état de charge en abscisse est noté ET et exprimé en % de la charge maximale d'un accumulateur. En ordonnée figure l'impédance Z de l'accumulateur, exprimée en ohms. L'accumulateur dont la caractéristique est représentée est un accumulateur SAFT nickel-cadmium de tension nominale 1,2 volts et de référence VSE AA. Les caractéristiques 10 à 13 représentent l'évolution de l'impédance de cet accumulateur en fonction de l'état de charge pour des courants égaux à:
- 20 mA alternatifs (caractéristique 10);
- 200 mA alternatifs (caractéristique 11);
- 200 mA alternatifs et 10 mA continus (caractéristique 12);
- 500 mA alternatifs et 800 mA continus (caractéristique 13).

Les courants alternatifs ont une fréquence de 0,1 Hz et il est nécessaire d'effectuer plusieurs mesures successives pour chaque point de chaque caractéristique afin d'éliminer certaines perturbations, notamment celles provenant d'un bruit de mesure.

On constate que pour les caractéristiques 10,11 et 12, il existe un point de rebroussement et donc deux valeurs d'impédance Z identiques pour deux états de charge différents. Par exemple, pour un courant de 20 mA alternatifs (caractéristique 10), une impédance Z de 0,13 ohms correspond à la fois à un état de charge de 22 et de 88%. Il n'est donc pas possible de connaître l'état de charge d'un accumulateur pour des courants faibles.

En revanche, la caractéristique 13 est de type univoque, c'est à dire qu'à une valeur de l'impédance Z de l'accumulateur correspond un seul et unique état de charge. Il est donc possible de connaître l'état de charge d'un accumulateur à partir de la valeur de son impédance interne si le courant débité de cet accumulateur est important.

Cependant, comme il est exclu de consommer en continu un courant important d'une batterie uniquement pour connaître son état de charge, la présente invention propose d'effectuer des mesures ponctuelles, en consommant pendant des temps brefs un courant important par génération d'impulsions de décharge potensiostatiques, c'est à dire de tension, comme il sera vu par la suite.

La figure 2 représente la caractéristique correspondant à l'admittance de deux accumulateurs nickelcadmium en fonction de leur état de charge, cette caractéristique étant obtenue par décharge impulsionnelle potentiostatique de durée inférieure à 100 ms.

L'axe des ordonnées est gradué en mS correspondant à l'admittance Y (Y=I/U) des accumulateurs dont les caractéristiques sont référencées 20 et 21. Ces caractéristiques correspondent respectivement à celles d'accumulateurs SAFT au nickel-cadmium de type VR AA et VSE AA. On constate que ces caractéristiques sont sensiblement linéaires. Il est donc préférable, lorsque les caractéristiques d'admittance sont linéaires, de déterminer l'état de charge d'accumulateurs directement à partir de l'admittance présentée par ces accumulateurs.

La présente invention se propose donc d'exploiter préférentiellement la caractéristique d'admittance d'un accumulateur lorsqu'un courant important est prélevé de cet accumulateur par application d'impulsions potentiostatiques.

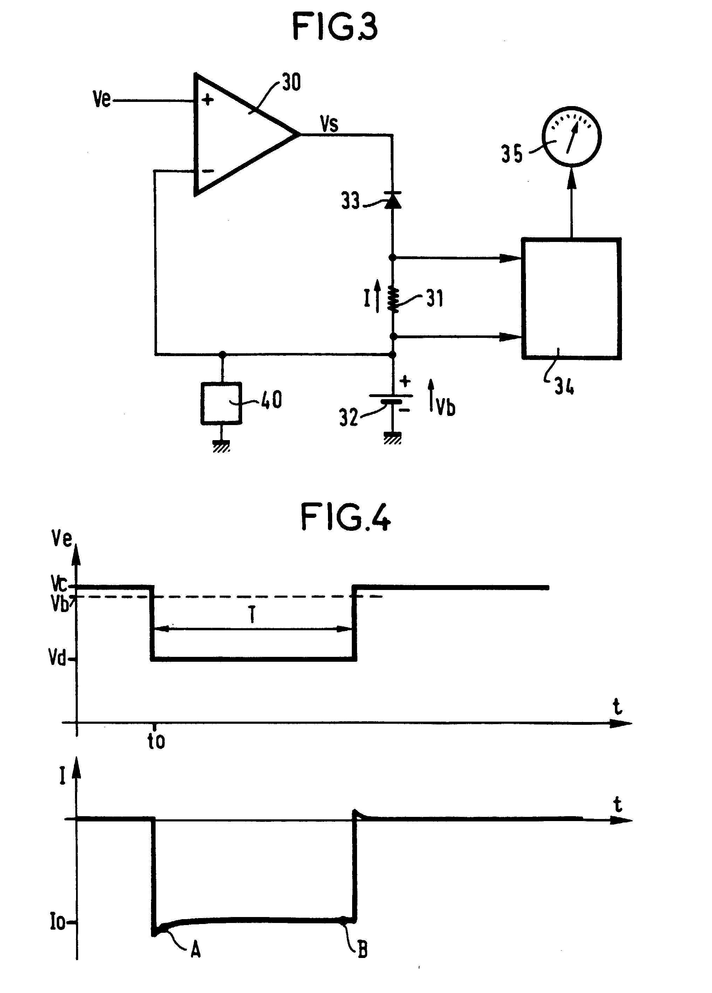

La figure 3 représente un dispositif permettant d'appliquer une impulsion potentiostatique à un accumulateur.

Un signal Ve de commande est appliqué à l'entrée non-inverseuse d'un potentiostat 30, par exemple constitué par un amplificateur opérationnel permettant de fournir un courant de sortie important. L'entrée inverseuse du potentiostat 30 est reliée à l'électrode positive d'un accumulateur 32 dont on désire connaître l'état de charge. L'électrode négative de l'accumulateur 32 est connectée à la masse. La sortie du potentiostat 30 est reliée à la cathode d'une diode 33 dont l'anode est reliée à une borne d'une résistance shunt 31. L'autre borne de la résistance shunt 31 est connectée à l'entrée inverseuse du potentiostat 30. En parallèle de la résistance shunt 31 est connecté un dispositif 34 de traitement de la tension mesurée aux bornes de la résistance 31, représentative du courant qui traverse le potentiostat 30 pendant les périodes de mesure d'état de charge et donc de l'admittance de l'accumulateur 32. Le dispositif 34 de traitement coopère avec un indicateur 35 de l'état de charge de l'accumulateur 32. L'accumulateur 32 peut bien entendu également être remplacé par une batterie d'accumulateurs.

La figure 4 est un chronogramme du signal de commande Ve et du courant de décharge impulsionnelle délivré par l'accumulateur 32.

Le signal de commande Ve présente une tension Vc supérieure ou égale à la tension nominale Vb de l'accumulateur 32 lorsqu'aucune impulsion permettant d'estimer l'état de charge de l'accumulateur 32 n'est générée. La tension de sortie Vs du potentiostat 30 est donc égale à Vc. Aucun courant ne traverse la résistance shunt 31 puisque Vs est supérieur à Vb. Cet état correspond à un état de repos du système de mesure d'état de charge.

A un temps t0, le signal Ve passe à une tension de décharge Vd. Ce brusque changement du signal de commande correspond à une impulsion potentiostatique destinée à permettre la mesure de l'état de charge de l'accumulateur 32 et de durée T. La tension de sortie Vs passe alors à Vd inférieur à la tension Vb. La tension aux bornes de l'accumulateur 32 est alors égale à Vd et un courant important traverse le potentiostat 30 par l'intermédiaire de la résistance shunt 31. Ce courant, noté I₀, varie dans le même sens que l'admittance présentée par cet accumulateur.

Le chronogramme I=f(t) de la figure 4 montre l'évolution du courant I traversant la résistance shunt 31. Au temps t₀, la décharge impulsionnelle présente un pic, puis se stabilise à une valeur I₀. Ce courant I₀ peut être très important, par exemple de l'ordre de 15A pour des accumulateurs nickel-cadmium de petite capacité. La mesure du courant I₀ par le dispositif 34 permet de déterminer l'état de charge de l'accumulateur 32 et de l'afficher sur l'indicateur 35. Le dispositif 34 peut déterminer soit l'admittance, soit l'impédance de l'accumulateur 32, en fonction de l'allure de ces caractéristiques (fig.1 et 2). Le dispositif 34 comprend par exemple un échantillonneur-bloqueur qui mesure la tension aux bornes de la résistance 31 à un temps Δt suivant t0. Le temps Δt est préférentiellement suffisamment important pour que la mesure de I₀ soit effectuée à un temps éloigné du début de l'impulsion. En effet, la variation du courant I₀ au début de l'impulsion est importante et la mesure de I₀ au point A ne sera pas aussi précise que celle effectuée à un point B situé préférentiellement à un instant précédant immédiatement le temps t0+T où le signal de commande Ve repasse à Vc, mettant ainsi fin à la mesure de l'état de charge. L'instant de mesure correspond au moment où la tension aux bornes de la résistance shunt 31 est mesurée. L'échantillonneur-bloqueur effectuant cette mesure est donc commandé en fonction de la durée T que l'on aura intérêt à minimiser afin de réduire la consommation de courant nécessitée pour l'évaluation de l'état de charge. Cette durée T dépend notamment du type d'accumulateurs utilisés et de la précision souhaitée. Le choix de la durée T dépend d'un compromis entre la précision souhaitée et l'énergie consommée par la mesure, étant donné qu'une durée T importante permet d'obtenir une bonne précision de la mesure de l'état de charge au détriment d'une puissance consommée importante.

Comme le courant mesuré aux bornes de la résistance shunt 31 est proportionnel à l'état de charge de l'accumulateur, à chaque nouvelle impulsion de décharge, une nouvelle estimation de cet état de charge est effectuée. De telles estimations peuvent par exemple être effectuées cycliquement sur commande d'un signal d'horloge, afin de permettre de suivre régulièrement l'évolution de l'état de charge. Selon un autre mode de réalisation, les impulsions de tension de Ve sont générées sur commande de l'utilisateur, lorsque celui-ci veut connaître l'état de charge de l'accumulateur.

Un des avantages de l'invention est que la décharge impulsionnelle est calibrée, c'est à dire que l'accumulateur 32 fournit une tension Vd pendant la mesure de l'état de charge. Si cette tension Vd est suffisante pour permettre le fonctionnement d'un circuit électrique 40 alimenté par l'accumulateur 32, aucune perturbation du circuit électrique 40 n'est engendrée par la mesure de l'état de charge.

A titre d'exemple, lorsque le dispositif de la figure 3 est utilisé pour mesurer l'état de charge d'une batterie de 10 accumulateurs en série et chacun de tension nominale 1,2 volts, la tension Vc peut être égale à 15 volts, et Vd à 10 volts, lorsque 10 volts suffisent pour alimenter le circuit 40 dont la batterie constitue la source d'alimentation.

Il faut donc que la tension Vd imposée aux bornes du générateur électrochimique 32 pendant la mesure de son état de charge soit supérieure ou égale à la tension minimale d'alimentation du circuit 40.

Un autre avantage de l'invention est que la mesure du courant de décharge permet de déterminer directement l'admittance Y de l'accumulateur testé, puisque la relation suivante est respectée: Y=I₀/Vd. En fait la mesure de I₀ permet d'obtenir une grandeur proportionnelle à Y, puisqu'il est nécessaire de tenir compte du courant passant par la résistance shunt 31. Ainsi, lorsque Y varie linéairement avec l'état de charge de l'accumulateur 32, comme c'est le cas pour les deux accumulateurs VR AA et VSE AA, la connaissance de I₀ donne directement l'état de charge de cet accumulateur.

La contrainte en tension est la même pour des accumulateurs de même type, quel que soit leur capacité. Une contrainte potentiostatique ne peut détruire un accumulateur de petite capacité. Cependant, il est nécessaire de tenir compte de la capacité de l'accumulateur pour pouvoir exploiter la mesure de courant effectuée.

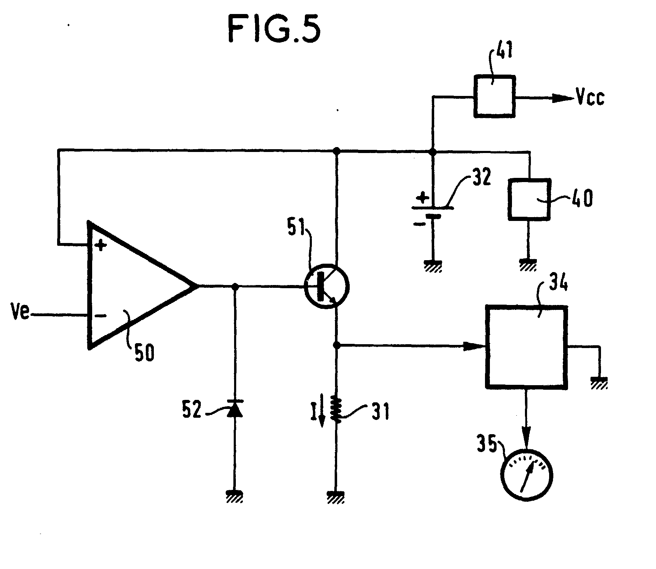

L'utilisation du dispositif de la figure 3 suppose cependant celle d'un potentiostat 30 capable de fonctionner à des courants importants. C'est pourquoi le dispositif de la figure 5 est préférable à celui de la figure 3.

Le dispositif de la figure 5 diffère de celui de la figure 3 en ce que le potentiostat est remplacé par un amplificateur opérationnel 50 classique dont la sortie est reliée à un élément 51 d'amplification de puissance, servant de charge et ici constitué par un transistor bipolaire, à travers lequel l'accumulateur 32 va pouvoir faire circuler un courant. La sortie de l'amplificateur opérationnel 50 est connectée à la base du transistor 51 dont l'émetteur est relié à la résistance 31 de shunt. Cette résistance 31 est de faible valeur afin de consommer un minimum de courant. La base du transistor 51 est protégée contre les tensions négatives issues de l'amplificateur 50 par une diode 52 de protection. Le collecteur du transistor 51 assure la contre-réaction de l'amplificateur 50 et est relié à la borne positive de l'accumulateur 32.

Ce montage présente l'avantage d'employer des composants classiques et de bas prix. L'énergie moyenne dissipée par la résistance 31 et le transistor 51 est faible lorsque les impulsions potentiostatiques sont éloignées les unes des autres dans le temps et permet une miniaturisation des composants employés. Le transistor bipolaire 51 peut également être remplacé par un autre composant, par exemple par un transistor MOSFET de puissance ou un transistor bipolaire à grille isolée (IGBT).

Il est également possible de remplacer la résistance shunt 31 par un capteur à effet Hall, l'essentiel étant de réaliser une mesure du courant débité par l'accumulateur 32 à travers le transistor 51. Il est cependant alors nécessaire de modifier la structure du dispositif 34.

La génération d'impulsions de tension de décharge permet également de s'affranchir de la connaissance du type d'accumulateurs employés, c'est à dire du couple électrochimique, contrairement à la méthode de l'état de la technique. Il suffit en effet de connaître la tension nominale Vb devant être fournie par l'accumulateur ou la batterie d'accumulateurs pour déterminer immédiatement les tensions Vc et Vd respectant la relation Vd<Vb<Vc.

La durée d'application d'une impulsion est préférentiellement très brève, par exemple comprise entre 1 et 1000 ms.

De façon générale, le dispositif de mesure de l'état de charge d'un générateur électrochimique comporte:
- une charge, constituée dans la figure 3 par le potentiostat 30 et dans la figure 5 par le transistor 51, permettant de faire débiter sur commande au générateur électrochimique 32 à tester un courant de décharge suffisamment important pour que sa caractéristique d'impédance interne en fonction de son état de charge soit univoque;
- des moyens de mesure de ce courant de décharge, constitués par la résistance shunt 31, le dispositif de traitement 34 et l'indicateur 35;
- des moyens pour imposer une tension prédéterminée aux bornes du générateur électrochimique de sorte que la mesure du courant de décharge exprime directement l'état de charge du générateur électrochimique, ces moyens étant constitués dans la description précédente d'un potentiostat 30 ou d'un amplificateur opérationnel 50.

Bien entendu, la présente invention n'est pas limitée aux accumulateurs et s'applique également aux générateurs électrochimiques constitués par des piles. Elle s'applique cependant uniquement aux générateurs électro-chimiques présentant une caractéristique d'impédance interne univoque en fonction de leur état de charge.

Les tensions d'alimentation du potentiostat 30 ou de l'amplificateur opérationnel 50, ainsi que du dispositif 34, peuvent être obtenues à partir de la tension fournie par le générateur électrochimique à tester, par exemple par l'intermédiaire d'un convertisseur continu-continu. Un tel convertisseur continu-continu est référencé 41 sur la figure 5 et fournit une tension d'alimentation Vcc du dispositif de mesure d'état de charge.

## Revendications

1. Procédé de mesure de l'état de charge d'un générateur électrochimique (32) présentant une tension nominale (Vb) entre deux bornes en l'absence de courant, et présentant aussi une impédance interne variable dont la valeur a une relation avec l'état de charge à mesurer, ce procédé comportant :
- l'application d'une contrainte impulsionnelle à ce générateur entre ses deux dites bornes
- la mesure d'une grandeur électrique dépendant de la dite impédance interne pour en déduire une valeur de l'état de charge à mesurer,
ce procédé étant caractérisé par le fait que ladite contrainte impulsionnelle est réalisée en maintenant temporairement la tension entre les deux dites bornes à une tension de contrainte (Vd) prédéterminée non nulle et suffisamment inférieure à ladite tension nominale (Vb) pour que ladite relation relie chaque valeur possible de ladite impédance interne à une seule valeur possible de l'état de charge à mesurer, ladite mesure constituant une mesure de cette impédance interne pendant l'application de cette contrainte.

2. Procédé selon la revendication 1, caractérisé en ce que ladite mesure est effectuée à la fin de ladite contrainte impulsionnelle.

3. Procédé selon l'une des revendications 1 et 2, caractérisé en ce que ladite tension (Vd) de contrainte est au moins égale à une tension minimale nécessitée par un circuit électrique (40) dont la source d'alimentation est constituée par ledit générateur électro-chimique (32).

4. Procédé selon l'une des revendications 1 à 3, caractérisé en ce qu'il est appliqué à la mesure de l'état de charge d'un accumulateur ou d'une batterie d'accumulateurs de type nickel-cadmium.

## Patentansprüche

1. Verfahren zur Messung des Ladezustands eines elektrochemischen Generators (32), der zwischen zwei Anschlußklemmen bei Nichtvorhandensein von Strom eine nominale Spannung (Vb) aufweist, und der auch eine variable innere Impedanz aufweist, deren Wert eine Beziehung mit dem zu messenden Ladezustand hat, wobei dieses Verfahren umfaßt:
- das Anlegen einer Impulslast an diesen Generator zwischen seinen beiden Anschlußklemmen,
- die Messung einer elektrischen Größe, die von der inneren Impedanz abhängt, um einen Wert des zu messenden Ladezustands abzuleiten,
wobei das Verfahren dadurch gekennzeichnet ist, daß die Impulslast unter zeitweisem Halten der Spannung zwischen den beiden Anschlußklemmen auf einer vorbestimmten Lastspannung (Vd), die nicht null und ausreichend geringer als die nominale Spannung (Vb) ist, ausgeführt wird, damit die Beziehung jeden möglichen Wert der inneren Impedanz mit einem einzigen möglichen Wert des zu messenden Ladezustands verbindet, wobei die Messung eine Messung dieser inneren Impedanz während des Anlegens dieser Last bildet.

2. Verfahren nach Anspruch 1, dadurch gekennzeichnet, daß die Messung am Ende der Impulslast ausgeführt wird.

3. Verfahren nach einem der Ansprüche 1 und 2, dadurch gekennzeichnet, daß die Lastspannung (Vd) wenigstens gleich einer minimalen Spannung ist, die eine elektrische Schaltung (40) erfordert, deren Spannungsquelle aus dem elektrochemischen Generator (32) besteht.

4. Verfahren nach einem der Ansprüche 1 bis 3, dadurch gekennzeichnet, daß es zur Messung des Ladezustands eines Akkumulators oder einer Akkumulatorenbatterie vom Nickel-Cadmium-Typ angewendet wird.

## Claims

1. A method of measuring the state of charge of an electrochemical storage unit (32) presenting a nominal voltage (Vb) between two terminals in the absence of current, and also presenting a variable internal impedance, the value of which is related to the state of charge to be measured, the method including:
applying a pulse stress to the storage unit between its two said terminals;
measuring an electrical magnitude dependent on the said internal impedance in order to deduce a value for the state of charge to be measured;
the method being characterized by the fact that said pulse stress is applied by temporarily maintaining the voltage between the two said terminals at a predetermined, non-zero, stress voltage (Vd) which is lower than said nominal voltage (Vb) by an amount that is sufficient for said relationship to associate each possible value of said internal impedance to a single possible value for the state of charge to be measured, said measurement constituting a measurement of said internal impedance during the application of said stress.

2. A method according to claim 1, characterized in that said measurement is performed at the end of said pulse stress.

3. A method according to claim 1 or 2, characterized in that said stress voltage (Vd) is not less than a minimum voltage required by an electrical circuit (40) whose power source is constituted by said electrochemical storage unit (32).

4. A method according to any one of claims 1 to 3, characterized in that it is applied to measuring the state of charge of a secondary cell or of a battery of nickel-cadmium type secondary cells.
